# DEMANDE DE BREVET EUROPEEN

(11) **EP 1 798 761 A2**
(43) Date de publication de la demande: **20.06.2007**
(21) Numéro de dépôt: 06301214.0
(22) Date de dépôt: 05.12.2006
(51) Int. Cl.: H01L 21/316, H01L 21/3205, H01L 21/762

(54) **Procédé de fabrication de composant comportant au moins une couche monocristalline sur un substrat**

(30) Priorité: 09.12.2005 FR 0512527
(71) Demandeur: XBYBUS, 75020 Paris (FR)
(72) Inventeur: Ancilotti, Michel, 44390, Nort sur Erdre (FR); Tauzinat, Pierre, 75016, Paris (FR); Lainat, Frédéric, 44850, Ligne (FR); Briere, Olivier, 44450, Barbechat (FR); Carriot, Olivier, 44220, Coueron (FR); Gadot, Gérard, 44119, Treillieres (FR)
(74) Mandataire: Grynwald, Albert

(57) **Abrégé**

L'invention se rapporte à un procédé de fabrication de composant comprenant un substrat monocristallin sur lequel est déposée au moins une couche monocristalline, le procédé comprenant une ou plusieurs étapes de dépôt de couches monocristallines par pulvérisation d'un métal ou d'un semiconducteur dans un plasma de gaz, et le procédé étant caractérisé en ce que la vitesse de dépôt des atomes est inférieure à la vitesse d'homogénéisation de ces atomes entre eux.

## Description

La présente invention concerne un procédé de fabrication de composant comportant une superposition d'une ou plusieurs couches monocristallines sur un substrat, également monocristallin. Les couches monocristallines sont des couches de silicium et/ou germanium, ou bien des couches isolantes, notamment formées d'oxyde de silicium. Ainsi, le procédé de fabrication permet, par exemple, de fabriquer un composant comportant un substrat de silicium monocristallin sur lequel on dépose une couche isolante, à laquelle on superpose une couche de silicium et/ou germanium, notamment monocristallin.

Ce procédé permet également de fabriquer un composant comportant un substrat de silicium monocristallin sur lequel on dépose une couche de silicium également monocristallin.

Dans une autre application, on fabrique un composant caractérisé en ce que le substrat est un isolant monocristallin, composé d'un oxyde de métaux ou de semi-conducteurs, sur lequel on dépose par exemple une couche de silicium et/ou germanium monocristallin.

L'oxyde de métaux ou de semi-conducteurs est, dans une réalisation, un isolant tel que du quartz ou du saphir.

Les substrats composés de type silicium sur isolant (SOI) sont utilisés dans la fabrication des circuits intégrés avancés (nano et microélectroniques), mais aussi pour la fabrication de composants semi-conducteurs discrets, ou de micro-systèmes MEMS. L'un des principaux avantages de l'utilisation d'un substrat SOI vis à vis d'un substrat Silicium, est une meilleure isolation des transistors des circuits intégrés (faibles courant de fuite), qui se traduit par une consommation réduite d'énergie. Ce gain en isolation est dû, notamment, à la couche de diélectrique interposée entre un substrat support et la couche active en Silicium mono-cristallin. Les circuits intégrés basés sur le SOI sont aussi adaptés à des usages en environnements sévères (Température, Radiations).

Parmi les nombreuses techniques proposées pour la fabrication de plaques de silicium sur isolant, on peut citer la technologie « SmartCut TM» et la technologie « SIMOX ».

La technologie SmartCut TM est aujourd'hui devenue le standard de l'industrie pour réaliser des substrats SOI. Cette technique consiste à créer, par implantation d'hydrogène dans un substrat silicium mono-cristallin oxydé thermiquement en surface, une zone fragile. Le matériau (Substrat A) ainsi constitué est associé par collage moléculaire sur un second substrat B préalablement oxydé thermiquement. Après clivage mécanique, facilité par la présence de la zone fragile dans le substrat A, un substrat SOI composé de trois couches (Si-Si02-Si) est obtenu. Il est nécessaire ensuite d'amincir la couche superficielle de silicium, et ceci est réalisé par un polissage mécano-chimique.

Ce procédé est assez complexe et coûteux, et nécessite un parc complet d'équipements. Cette technique est par ailleurs limitée pour les épaisseurs les plus fines de la couche de silicium superficielle (dite active) et celle de l'oxyde (dite BOX). En effet, pour les épaisseurs les plus fines, la mésuniformité d'épaisseur sur le diamètre du substrat, due à l'étape de polissage, est un facteur limitatif pour les composants semi-conducteurs réalisés à partir des substrats.

La technologie SIMOX, quant à elle, consiste à implanter des ions oxygène O⁺ au coeur d'un substrat de silicium monocristallin, de manière à créer directement un empilement Silicium/Oxyde de silicium/Silicium.

Les ions oxygène traversent donc la couche supérieure de substrat pour atteindre la couche isolante. L'inconvénient majeur de cette technologie est que le passage des ions oxygène introduit des défauts dans la couche d'oxyde et dans la couche supérieure de silicium. Il est donc nécessaire d'effectuer plusieurs recuits pour diminuer ces défauts, défauts qui sont impossibles à éliminer en totalité.

Cette technique est par ailleurs réputée peu adaptée à la réalisation des substrats SOI présentant une couche active Silicium très mince, et/ou une couche de SiO2 (BOX) très fine.

En conséquence, cette technique n'est pas utilisée pour les substrats composés dédiés aux dernières générations de technologies semi-conducteur.

Cette technique nécessite l'usage d'équipements spécifiques et grands consommateurs d'énergie.

L'invention vise à remédier à au moins l'un de ces inconvénients, en proposant un procédé permettant de fabriquer des empilements quasiment parfaits dans une seule enceinte.

Une autre réalisation concerne un procédé de fabrication de substrat composé comportant un substrat d'isolant mono-cristallin sur lequel on dépose une couche de silicium et/ou germanium mono-cristallin. Le substrat d'isolant est par exemple composé de Quartz (Forme cristalline de la silice SiO₂), ou d'un autre type d'oxyde de métaux ou d'oxyde de semi-conducteurs présentant des caractéristiques optiques et/ou d'isolation électrique choisies.

Ce type de substrat composé est généralement apprécié pour ses propriétés de transparence dans le visible, et par ailleurs pour ses propriétés de très bonne isolation électrique. Des composants micro ou nanoélectroniques peuvent être réalisés sur de tels substrats, afin de fabriquer des circuits intégrés destinés à diverses applications dont l'optoélectronique (Ecrans plats, capteurs de type CCD, imageurs CMOS) la photonique et la communication (radiofréquence RF ou haute fréquence HF).

Ce type de substrat composé est généralement fabriqué en utilisant la technologie Smart-Cut (TM). Cette technologie, majoritairement utilisée pour réaliser des substrats SOI, consiste à associer par collage une plaque circulaire de silicium et/ou germanium mono-cristallin transférée sur une plaque circulaire de même diamètre en silice. Les limitations associées à cette technique pour fabriquer le SOQ, sont issues des différences de coefficient d'expansion thermique des matériaux.

En utilisant la technologie Smart-Cut, le transfert de la couche de silicium et/ou germanium impose une certaine épaisseur de cette couche.

L'invention vise à proposer une méthode de fabrication nouvelle, permettant de réaliser des substrats de grande qualité par un procédé simple et peu coûteux dans une seule enceinte. Cette méthode permet par ailleurs de réaliser des couches de silicium et/ou germanium mono-cristallin de très faible épaisseur.

L'invention concerne ainsi la fabrication de composant comprenant un substrat monocristallin sur lequel est déposée au moins une couche monocristalline, le procédé comprenant une ou plusieurs étapes de dépôt de couche monocristalline par pulvérisation d'un métal ou d'un semi-conducteur dans un plasma de gaz, et le procédé étant caractérisé en ce que la vitesse de dépôt des atomes est inférieure à la vitesse d'homogénéisation de ces atomes entre eux. La vitesse de dépôt est ainsi comprise entre 2 à 10nm/min.

Un tel procédé, du fait de la vitesse de dépôt relativement lente, permet de réaliser une épitaxie à faible température, notamment entre 350°C et 500 °C. En effet, dans l'état de l'art de la technique, notamment dans les procédés de type dépôt par vapeur chimique (CVD : Chemical Vapor Deposition), de telles épitaxies sont réalisées à des températures proches du point de fusion des métaux ou des semi-conducteurs, par exemple aux alentours de 1000°C. Dans ce cas, du fait de cette haute température, au cours d'une des étapes du procédé, les dopants présents dans la couche sur laquelle est effectué le dépôt sont rediffusés dans le métal ou le semi-conducteur pulvérisé, par exemple du silicium. Dans ce cas, il y a un phénomène de rétro-diffusion, ayant pour conséquence des mauvaises jonctions électriques, et des défauts au niveau des interfaces. Par ailleurs, à cause de cette diffusion, la couche déposée n'est pas homogène, par exemple en terme de concentration de dopants.

Au contraire, dans le procédé décrit ici, la température de dépôt est beaucoup plus faible, ce qui a pour conséquence de diviser par 30 ou 40 la vitesse de diffusion des dopants par rapport aux techniques existantes. En conséquence, les composants fabriqués présentent des jonctions électriques abruptes, quasiment sans défaut, et des couches homogènes.

Par ailleurs, cette vitesse lente de dépôt permet de contrôler parfaitement l'épaisseur de métal ou du semi-conducteur ou d'isolant déposé, c'est à dire l'épaisseur de l'épitaxie. Ainsi, on peut obtenir une précision de l'ordre d'une couche atomique.

Dans une application, ce procédé peut être utilisé pour la fabrication de composant comprenant un substrat en silicium monocristallin sur lequel est déposée une couche isolante à laquelle est superposée une couche de silicium et/ou germanium, le procédé comprenant les étapes suivantes :
- au cours d'une première étape on pulvérise, sur une plaque de silicium monocristallin, un métal ou un semi-conducteur ou un isolant dans un plasma d'oxygène et d'argon, de manière à créer une couche d'oxyde sur la plaque pour former la couche isolante, puis
- au cours d'une seconde étape on pulvérise par plasma du silicium et/ou du germanium sur cette couche d'oxyde.

De manière plus générale, selon les réalisations, le matériau monocristallin du substrat monocristallin est compris dans le groupe comprenant du silicium, du germanium et un matériau riche en isotope 28 du silicium, le Si28.

Le procédé est, par exemple, tel que toutes les étapes sont réalisées dans une même enceinte à vide, dans laquelle se trouve le substrat sur lequel vont s'effectuer les dépôts, et des cibles des métaux, semi-conducteurs ou isolants destinés à être pulvérisés.

Selon les réalisations, le procédé de fabrication peut comporter différentes étapes, et permettre la fabrication de différents types de composants :
Dans un premier exemple, le procédé est tel que le substrat est un substrat de silicium monocristallin, et le procédé comprend une étape de dépôt de silicium monocristallin.
Dans ce cas, le composant obtenu comporte deux couches de silicium monocristallin, ayant chacune des caractéristiques électriques qui peuvent être différentes. Un tel composant sera décrit en détail ultérieurement.
Ce mode de réalisation peut également être appliqué dans le cas où l'on remplace le silicium par du germanium ou par une combinaison des deux.

Dans un deuxième exemple, le procédé est tel que le substrat est un substrat de silicium monocristallin et le procédé comprend deux étapes de dépôt :
- une première étape au cours de laquelle on pulvérise du silicium dans un plasma d'argon et d'oxygène, créant ainsi une couche d'oxyde de silicium monocristallin, et
- une deuxième étape au cours de laquelle on pulvérise du silicium dans un plasma d'argon, créant ainsi une couche de silicium monocristallin.

Dans ce cas le composant fabriqué est un composant de type SOI (Silicium sur Isolant, « Silicon On Insulator »).

Ce mode de réalisation est également applicable pour la fabrication d'un composant Germanium sur Isolant.

Dans un troisième exemple, le procédé est tel que le substrat est un substrat d'oxyde de métal ou de semi-conducteurs, isolant, et le procédé comprend une étape de dépôt de silicium et/ou germanium monocristallin (Exemple : Silicon On Quartz (SOQ)).

Dans une autre réalisation, le matériau déposé au cours d'une étape est un matériau semi-conducteur compris dans le groupe comprenant : le silicium, le germanium, et un matériau riche en isotope 28 du silicium : le Si28.

Selon que l'on pulvérise, au cours d'une étape de dépôt, uniquement du silicium, ou uniquement du germanium, ou les deux produits simultanément, le composant créé sera respectivement de type SOI, GeOI ou SiGeOI.

Les gaz introduits dans l'enceinte afin de créer le plasma varient selon l'étape de pulvérisation effectuée.

Ainsi, dans une réalisation, le plasma utilisé au cours d'une étape de dépôt est un plasma d'argon et d'oxygène. Dans ce cas, la couche déposée est un couche isolante d'oxyde de métal ou de semi-conducteur.

Dans une autre réalisation, le plasma utilisé au cours d'une étape de dépôt est un plasma d'argon, la couche déposée étant alors une couche de métal ou de semi-conducteur monocristallin.

Dans ce cas, on pourra, par exemple, injecter simultanément de l'oxygène et de l'argon lors de la première étape, puis stopper l'injection de l'oxygène au moment du passage à la seconde étape.

Dans une réalisation, pour obtenir que la vitesse de dépôt des atomes soit inférieure à la vitesse d'homogénéisation de ces mêmes atomes entre eux, la source de production du plasma est contrôlée par des moyens différents de ceux utilisés pour le contrôle de la polarisation des cibles servant aux différentes pulvérisations, notamment par une électrode différente des cibles ou du porte substrat.

Ainsi, il y a un découplage entre, d'une part, la création des ions servant à la pulvérisation et, d'autre part, la polarisation des cibles, cette polarisation déterminant le rendement de pulvérisation. Ce découplage permet de faire varier la vitesse d'homogénéisation en envoyant sur la couche d'oxyde des ions polarisés d'une façon telle qu'ils perdent leur énergie cinétique à l'impact sur cette couche, permettant ainsi d'augmenter la mobilité des atomes déposés.

Dans une réalisation, le plasma utilisé est un plasma inductif, c'est-à-dire créé par une antenne externe, par exemple émettant dans une gamme de fréquences allant de 0.1 à 100 MHz, au travers d'un diélectrique.

On peut ainsi créer un plasma de type ICP (plasma à couplage inductif), ou de type TCP (plasma à couplage transformateur). De cette façon, la géométrie de l'antenne peut être choisie parmi plusieurs configurations, de manière à sélectionner celle assurant la plus grande homogénéité du plasma.

Par ailleurs, le fait d'utiliser une antenne externe permet de diminuer les risques de contamination métallique du plasma par des parasites issus de l'antenne et/ou du diélectrique. Ainsi il est également utile, dans une réalisation, d'utiliser un diélectrique en un matériau non métallique tel que du verre.

Dans une réalisation, les cibles utilisées pour les pulvérisations sont polarisées en utilisant une polarisation comprise dans le groupe comprenant : une polarisation de type radiofréquence (RF), une polarisation en courant continu (DC) ou une polarisation en courant continu (DC) pulsé.

Dans ce dernier cas, il est nécessaire que chaque impulsion de tension comporte une excursion de tension positive, afin de maintenir la pulvérisation sur les matériaux semi-conducteurs et isolants. La polarisation en courant continu (DC) pulsé permet une stabilisation du procédé de pulvérisation cathodique, ceci en particulier pour des matériaux peu conducteurs. La polarisation RF étant, quant à elle adaptée, pour les matériaux isolants.

Dans une des réalisations, la première étape du procédé décrit ci-dessus consiste à déposer une couche d'oxyde sur un substrat de silicium monocristallin. Généralement, le substrat utilisé consiste en une plaque de silicium disponible dans le commerce, et qui est donc protégée par un oxyde. Dans ce cas, mais également dans d'autres modes de réalisation, il est utile d'ajouter au procédé une étape préliminaire qui consiste à enlever l'oxyde présent sur le substrat, notamment sur une plaque de silicium monocristallin. Pour ce faire, on utilise, par exemple, une méthode connue de nettoyage chimique, telle que le nettoyage RCA, développé par la « Radio Corporation of America ». Dans une autre réalisation, le nettoyage est réalisé par une méthode de recuit rapide (RTP) durant un temps variant de 30 secondes à 5 minutes.

Cette étape préliminaire peut également être effectuée dans d'autres modes de réalisation de l'invention.

Par ailleurs, il est également utile, une fois le composant finalisé, c'est-à-dire une fois tous les dépôts effectués, de déposer une couche protectrice sur la surface externe du composant. Ainsi, dans une réalisation, le procédé comprend une étape finale consistant à déposer, sur la couche supérieure, une couche de passivation destinée à protéger le composant. Cette couche, également appelée couche de barrière, permet d'éviter le passage d'impuretés pouvant altérer les qualités du composant silicium et/ou germanium sur isolant.

La couche supérieure est, par exemple, une couche de silicium ou de germanium monocristallin.

On connaît divers procédés pour réaliser une telle couche de passivation. Par exemple, la couche de passivation est réalisée en pulvérisant du silicium et/ou du germanium dans un plasma d'hydrogène. Cette possibilité présente l'avantage de ne pas nécessiter d'équipement particulier, puisqu'elle fait appel à un procédé voisin de celui employé pour le dépôt des couches d'oxyde et de silicium et/ou germanium.

Une autre solution consiste à introduire l'hydrogène atomique directement sous forme de gaz, et non pas en phase plasma. Dans ce cas, l'hydrogène réagit directement avec le silicium et/ou le germanium pour former des liaisons hydrures passivantes.

Dans le cas où le procédé est utilisé pour réaliser un composant de type SOI, et afin que le processus de fabrication soit le plus simple et le plus économique possible, il est utile que le métal ou le semi-conducteur pulvérisé au cours de toutes les étapes soit, dans une réalisation, du silicium. Ainsi, il suffit de disposer d'une seule cible de pulvérisation pour réaliser les différents dépôts. Dans ce cas, l'oxyde créé pour former la couche isolante est un oxyde de silicium.

Le composant créé dans cette configuration comprend un empilement silicium / oxyde de silicium / silicium et/ou germanium, qui est l'empilement le plus couramment utilisé, actuellement, dans l'industrie des circuits intégrés.

En revanche, l'oxyde de silicium ayant une très faible permittivité, avec une constante diélectrique k égale à 3.9, il est nécessaire, pour que le composant créé ait une capacité électrique acceptable, que la couche isolante soit très mince sans toutefois permettre le passage du courant. Mais la réalisation de telles couches, par exemple d'une épaisseur inférieure à 50 nanomètres, est relativement complexe, puisqu'il faut veiller à ce qu'il n'y ait pas un recouvrement incomplet de la surface de silicium, qui entraînerait des courants de fuite trop importants. Il faut donc un processus de fabrication extrêmement précis et minutieux.

Une solution pour remédier à cet inconvénient consiste, dans une réalisation au cours de laquelle on dépose un oxyde de métal ou de semi-conducteurs, à créer un oxyde à forte permittivité, par exemple dont la constante diélectrique k est comprise entre 15 et 30.

Ces oxydes ayant une permittivité plus élevée, il est possible de réaliser des couches plus épaisses, tout en conservant une bonne capacité électrique; on obtient une fabrication plus aisée, ce qui conduit à des couches de meilleure qualité.

Par ailleurs, l'oxyde de silicium présente, par rapport au silicium, un désaccord de maille relativement important, de l'ordre de 9,5%. Ce désaccord de maille a pour conséquence de rendre relativement difficile l'amorçage de l'épitaxie utilisée pour faire croître le silicium et/ou germanium cristallin sur le substrat. En outre, les interfaces silicium/oxyde présentent de nombreux défauts structuraux.

Pour améliorer la cristallinité de ces interfaces, il est utile, dans une réalisation, de créer, au cours de la première étape, un oxyde tel que le désaccord de maille entre cet oxyde et le silicium et/ou germanium soit inférieur à 6%.

Ainsi, selon la réalisation choisie, l'oxyde créé est compris dans le groupe comprenant : l'aluminate de lanthane (LaAlO₃), la zircone (oxyde de zirconium ZrO₂) stabilisée avec de l'oxyde d'yttrium Y₂O₃, (YZS), et l'oxyde de cérium (CeO₂).

La quantité d'oxyde d'yttrium présent dans la zircone est généralement de l'ordre de quelques pourcents, par exemple 8%.

Ces différents oxydes présentent les deux caractéristiques énoncées ci-dessus, puisqu'ils ont tous une forte permittivité, et que leurs désaccords de maille avec le silicium valent, respectivement, 1.21%, 5.35% et 0.35%.

Le procédé de fabrication décrit ci-dessus est tel qu'il permet la réalisation d'un composant silicium sur isolant et/ou germanium sur isolant et/ou silicium-germanium sur isolant de taille relativement importante. Par exemple, dans une réalisation, le composant créé a une forme de disque et un diamètre supérieur ou égal à 50 millimètres.

Ce composant sert de base pour la fabrication des circuits intégrés par dopage de la couche de silicium et/ou germanium.

Afin d'assurer une bonne qualité de ces circuits, il est nécessaire d'assurer de la bonne stabilisation des couches déposées et constituant le composant fabriqué. A cet effet, dans une réalisation, le procédé comprend une ou plusieurs étapes de recuit.

L'invention concerne également un composant présentant les caractéristiques de celles d'un composant fabriqué par un procédé du type ci-dessus.

D'autres caractéristiques et avantages de l'invention apparaîtront avec la description de certains de ses modes de réalisation, cette description étant effectuée à l'aide des figures sur lesquelles :
- la figure 1 représente un composant réalisé en utilisant un procédé conforme à l'invention,
- la figure 2 présente un système permettant de réaliser un composant selon un procédé conforme à l'invention, et
- la figure 3 présente un chronogramme des différentes étapes d'un procédé conforme à l'invention,
- la figure 4 présente un exemple d'empilement Silicium sur silicium, effectué selon un procédé conforme à l'invention.

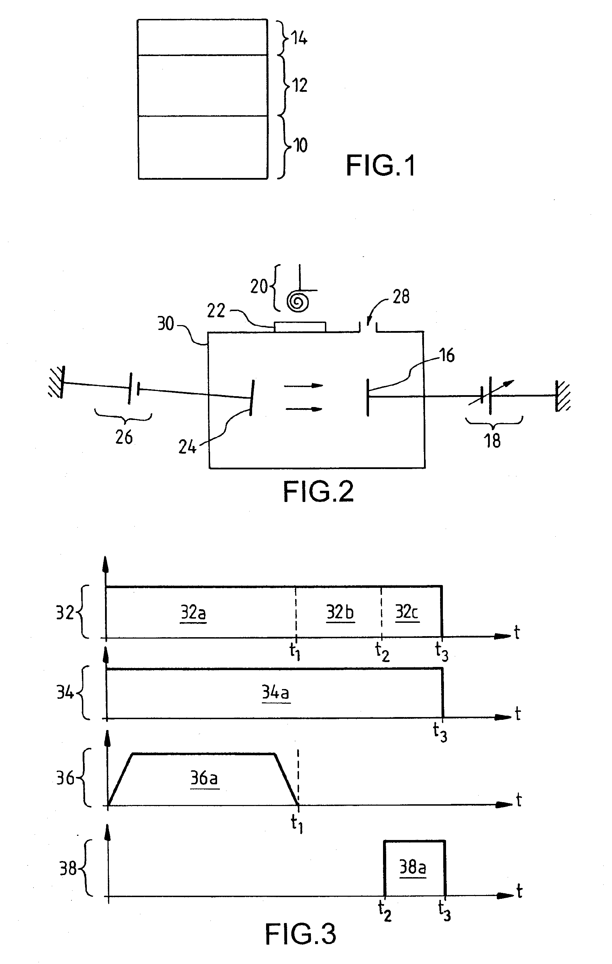

Sur la figure 1 on a représenté, en coupe, un composant obtenu par un procédé de fabrication conforme à l'invention, ce composant ayant la forme d'un disque de diamètre Supérieur ou égal à 50mm.

Ce composant comporte un substrat 10 de silicium monocristallin, tel par exemple qu'une plaque de silicium disponible dans le commerce. Cette plaque est au préalable décapée de son oxyde. En outre, le composant comporte une couche isolante 12 constituée d'un oxyde déposé par pulvérisation plasma, tel que l'oxyde de silicium (SiO₂), l'aluminate de lanthane (LaAlO₃), le zircone d'yttrium stabilisé (YZS), ou encore l'oxyde de cérium (CeO₂). Cette couche 12 a une épaisseur de 300 nanomètres.

La dernière couche 14 est une couche de silicium et/ou de germanium monocristallin déposée par pulvérisation plasma, qui a une épaisseur de 100 nanomètres.

Dans le cas où la dernière couche est une couche de silicium monocristallin, ce silicium peut être dopé.

La fabrication de ce composant est réalisée dans une enceinte à vide 30 telle que celle représentée sur la figure 2. La pression dans cette enceinte est, par exemple, de l'ordre de 0.1 à 1 Pa.

Dans l'enceinte 30 se trouve un substrat de silicium monocristallin, sous forme d'une plaque de silicium 16. Cette plaque de silicium sert de base pour recevoir les dépôts destinés à créer les différentes couches du composant. La plaque 16 est reliée à un moyen 18 de régulation de la température, afin que celle-ci ne dépasse pas les 600 °C au cours de la fabrication.

De manière plus précise, la température du substrat est généralement maintenue entre 375 et 450 °C. Dans un exemple, le procédé est tel que la température du substrat peut être abaissée en dessous de 300°C.

Le dispositif de production de plasma comporte une antenne radio fréquence planaire 20 et un diélectrique plan 22, réalisé en un matériau non métallique tel que le verre, afin d'éviter toute contamination métallique du plasma par les parois. Dans une autre réalisation, on peut utiliser une antenne hélicoïdale enroulée autour d'un tube diélectrique.

Dans l'exemple, le composant créé sera un empilement silicium/oxyde de silicium/silicium. A cet effet, l'enceinte 30 comporte uniquement une cible de silicium monocristallin 24. Si on souhaite réaliser d'autres empilements, il suffit d'installer, dans l'enceinte, une ou plusieurs cibles du métal ou semi-conducteurs ou isolant correspondant à l'oxyde que l'on souhaite créer.

Cette cible 24 est reliée à des moyens de polarisation 26, qui sont indépendants des moyens 20 et 22 de production du plasma. Dans un exemple, la cible est polarisée avec un générateur de courant continu pulsé, de type « DC pulsé ».

Pour effectuer les dépôts par plasma des différentes couches, on introduit successivement des gaz (28) selon un séquencement défini au préalable.

Un exemple de séquencement est illustré sur la figure 3. Cette figure comporte 4 chronogrammes montrant respectivement les différentes étapes du procédé de fabrication (chronogramme 32), le séquencement de l'introduction de gaz Argon dans l'enceinte (chronogramme 34), le séquencement de l'introduction d'oxygène dans l'enceinte (chronogramme 36), et le séquencement de l'introduction d'hydrogène dans l'enceinte (chronogramme 38).

La première étape représentée (32a) est l'étape de dépôt d'une couche d'oxyde de silicium sur un substrat en silicium 16. A cet effet, de l'argon (34a) et de l'oxygène (36a) sont introduits dans l'enceinte 30, et transformés en plasma par les moyens 20 et 22.

La réaction chimique ayant lieu entre les ions oxygène et la vapeur de silicium, majoritairement issue de la pulvérisation de la cible 24 par les ions argons, a pour effet la création de l'oxyde de silicium SiO pendant le transport du silicium dans le plasma.

Lorsque cet oxyde atteint le substrat 16, les atomes se réarrangent de manière à former de l'oxyde de silicium SiO₂. A l'instant t1, on a déposé une couche isolante de l'épaisseur souhaitée, et il faut donc passer à l'étape suivante (32b) dans le processus de fabrication.

A cet effet, l'introduction d'oxygène dans l'enceinte 30 est stoppée, et il ne reste que de l'argon.

Cet argon permet de pulvériser, par plasma, le silicium de la cible 24, afin de déposer une couche de silicium monocristallin sur la couche isolante précédemment déposée.

L'instant t2 marque la fin de l'étape de dépôt du silicium pur. Le composant est alors terminé.

Toutefois, il est utile de déposer, au cours d'une étape 32c, une couche supplémentaire, appelée couche de passivation.

Cette couche, destinée à protéger le composant de la corrosion, est réalisée en introduisant de l'hydrogène atomique dans l'enceinte (38a) qui réagit avec les atomes de la surface externe de silicium et/ou germanium pour faire les liaisons passivantes silicum-hydrogène et/ou germanium-hydrogène.

Une fois le procédé terminé, à l'instant t3, on stoppe l'introduction d'hydrogène dans l'enceinte.

Le temps total de réalisation du procédé peut varier entre 1min 30 et 15 min selon les vitesses de dépôt choisies.

La vitesse de dépôt de silicium est, par exemple, comprise entre 250 nm/min pour un dépôt microcristallin, et 2 à 10 nm/min pour un dépôt monocristallin.

Ainsi que décrit précédemment, un procédé selon l'invention peut être utilisé pour réaliser différents types de composants, notamment des composants comportant une couche de silicium monocristallin déposée sur un substrat de silicium monocristallin.

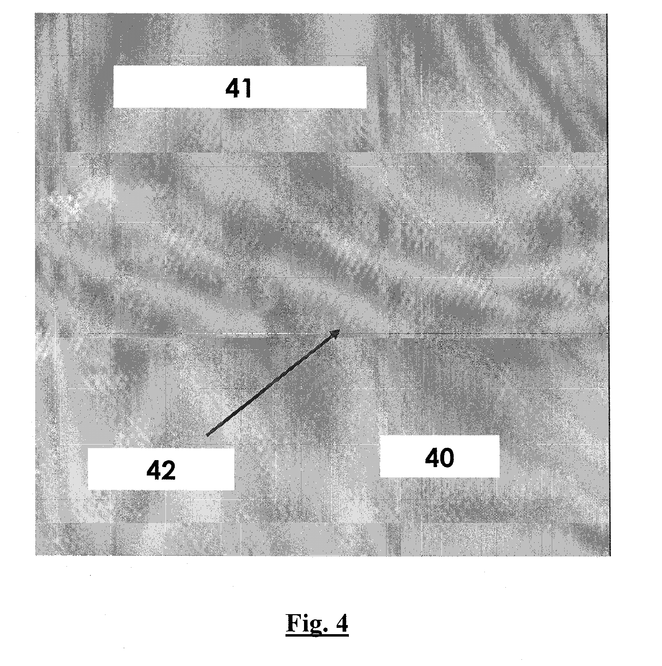

La figure 4 montre un exemple d'un tel composant, observé à l'aide d'un microscope électronique à transmission.

Sur cette figure on voit apparaître un substrat de silicium monocristallin 40 sur lequel on a fait croître, par pulvérisation plasma, une couche 41, ou épitaxie, de silicium monocristallin. La couche 41 et le substrat 40 sont séparés par une interface 42.

Les caractéristiques électriques des deux couches peuvent être différentes puisqu'on peut, par exemple, disposer d'un substrat ayant une résistivité de 5 à 10 ohms par centimètre, et faire croître une couche de silicium épitaxié ayant une résistivité de l'ordre de 100 ohms par centimètre. Selon les réalisations, le silicium déposé au cours du procédé peut être complété par des dopants, de type N ou de type P.

On voit clairement, sur cette figure, que les atomes de silicium déposés par pulvérisation se sont réarrangés et homogénéisés, de manière à former un arrangement parfait avec les atomes du substrat.

## Revendications

1. Procédé de fabrication de composant comprenant un substrat monocristallin sur lequel est déposée au moins une couche monocristalline, le procédé étant **caractérisé en ce qu'**il comprend une ou plusieurs étapes de dépôt de couches monocristallines par pulvérisation d'un métal ou de semi-conducteurs dans un plasma de gaz, et **en ce que** la vitesse de dépôt des atomes est inférieure à la vitesse d'homogénéisation de ces atomes entre eux.

2. Procédé selon la revendication 1 **caractérisé en ce que** les cibles utilisées pour les pulvérisations sont polarisées en utilisant une polarisation comprise dans le groupe comprenant : une polarisation (26) de type courant continu (DC) ou courant continu pulsé, ou radiofréquence (RF).

3. Procédé selon la revendication 1 ou 2 **caractérisé en ce que** le matériau monocristallin du substrat monocristallin est compris dans le groupe comprenant : du Silicium, du Germanium, et un matériau riche en isotope 28 du silicium, le Si28.

4. Procédé selon l'une des revendications 1 à 3 **caractérisé en ce que** le matériau déposé au cours d'une étape est un matériau semi-conducteur compris dans le groupe comprenant : le silicium, le germanium, et un matériau riche en isotope 28 du silicium, le Si28.

5. Procédé selon l'une des revendications précédentes, **caractérisé en ce que** le plasma utilisé au cours d'une étape est un plasma d'argon et d'oxygène, une couche déposée étant alors une couche isolante d'oxyde de métal ou de semi-conducteurs

6. Procédé selon l'une des revendications précédentes, **caractérisé en ce que** le plasma utilisé au cours d'une étape est un plasma d'argon, la couche déposée étant alors une couche de métal ou de semi-conducteurs monocristallin.

7. Procédé selon l'une des revendications précédentes dans lequel le substrat est un substrat de silicium monocristallin, et le procédé comprend une étape de dépôt de silicium monocristallin.

8. Procédé selon l'une des revendications 1 à 7 **caractérisé en ce qu'**il comprend un dépôt d'une couche monocristalline isolante d'oxyde de métal ou de semi-conducteurs, sur un substrat monocristallin semi-conducteurs

9. Procédé selon l'une des revendications 1 à 7 dans lequel le substrat est un substrat de silicium monocristallin et le procédé comprend deux étapes de dépôt :
- une première étape au cours de laquelle on pulvérise du silicium dans un plasma d'argon et d'oxygène, créant ainsi une couche d'oxyde de silicium monocristallin, et
- une deuxième étape au cours de laquelle on pulvérise du silicium dans un plasma d'argon, créant ainsi une couche de silicium monocristallin.

10. Procédé selon l'une des revendications 1 à 7 dans lequel le substrat monocristallin est un substrat d'oxyde de métal ou de semi-conducteurs, isolant tel que par exemple le quartz ou le saphir, le procédé comprenant une étape de dépôt de silicium et/ou germanium monocristallin.

11. Procédé selon l'une des revendications précédentes **caractérisé en ce que** le plasma utilisé est un plasma inductif, c'est-à-dire créé par une antenne externe (20) au travers d'un diélectrique (22).

12. Procédé selon la revendication 12 **caractérisé en ce que** la source de production du plasma est contrôlée indépendamment de la polarisation des cibles servant aux différentes pulvérisations, notamment par une électrode différente des cibles ou du porte substrat.

13. Procédé selon les revendications 12 et 13 **caractérisé en ce que** l'antenne externe (20) émet dans une gamme de fréquences allant de 0.1 à 100 MHz.

14. Procédé selon l'une des revendications précédentes comprenant l'étape préliminaire d'enlever l'oxyde présent sur la plaque de silicium monocristallin.

15. Procédé selon l'une des revendications précédentes comprenant l'étape finale de réalisation d'une couche de passivation destinée à protéger le composant.

16. Procédé selon la revendication 15 **caractérisé en ce que** la couche de passivation est réalisée en pulvérisant du silicium et/ou du germanium dans un plasma d'hydrogène.

17. Procédé selon l'une des revendications précédentes **caractérisé en ce que**, lorsque qu'une couche d'oxyde est déposée, l'oxyde créé est un oxyde à forte permittivité, par exemple dont la constante diélectrique k est comprise entre 15 et 30.

18. Procédé selon l'une des revendications précédentes **caractérisé en ce que** l'oxyde créé au cours de la première étape de pulvérisation est tel que le désaccord de maille entre cet oxyde et le silicium et/ou germanium est inférieur à 6%.

19. Procédé selon l'une des revendications précédentes dans lequel l'oxyde créé est compris dans le groupe comprenant : l'aluminate de lanthane (LaAlO₃), la zircone (oxyde de zirconium ZrO₂) stabilisée de l'oxyde d'yttrium, Y₂O₃ (YZS), et l'oxyde de cérium (CeO₂).

20. Procédé selon l'une des revendications précédentes **caractérisé en ce qu'**il comprend une ou plusieurs étapes de recuit, permettant une stabilisation des couches déposées.

21. Procédé selon l'une des revendications précédentes **caractérisé en ce que** le composant créé a une forme de disque et un diamètre supérieur ou égal à 50 millimètres.

22. Composant présentant les caractéristiques de celles d'un composant fabriqué par un procédé conforme à l'une des revendications précédentes.
